(19) Europäisches Patentamt

European Patent Office

Office européen des brevets

(11) **EP 1 223 577 A2**

(12) **EUROPEAN PATENT APPLICATION**

(43) Date of publication:
**17.07.2002 Bulletin 2002/29**

(51) Int Cl.7: **G11B 7/24**

(21) Application number: **02250177.9**

(22) Date of filing: **10.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **10.01.2001 JP 2002002258**
**12.01.2001 JP 2001005734**
**01.03.2001 JP 2001057392**

(71) Applicant: **Ricoh Company**
**Tokyo 143-8555 (JP)**

(72) Inventors:
• **Nakamura, Yuki**
  **Kanagawa-ken (JP)**
• **Katoh, Masaki**
  **Kanagawa-ken (JP)**

(74) Representative: **Lamb, Martin John Carstairs**
**MARKS & CLERK,**
**57-60 Lincoln's Inn Fields**
**London WC2A 3LS (GB)**

(54) **Phase change optical recording medium**

(57) A phase change optical recording medium is disclosed together with the methods for optimally initializing and recording such recording media, feasible for carrying out read/write/erase operations at multiple recording velocities ranging from 4.8 m/sec to 30 m/sec. Preferably, a recording layer included in the recording medium essentially consists of Ag, In, Sb and Te, with the proportion in atom % of a(Ag): b(In): c(Sb): d(Te), with $0.1 \leq a \leq 7$, $2 \leq b \leq 10$, $64 \leq c \leq 92$ and $5 \leq d \leq 26$, provided that $a + b + c + d \geq 97$. The method for initializing the recording medium with a scanning beam spot from a high power semiconductor laser is characterized by the energy density input by the beam spot during one period of through scan is equal to, or less than, 1000 J/$m^2$, scanning speed of beam spot is in the range of 3.5 m/sec to 6.5 m/sec, and the intensity of laser emission equal to, or greater than 330 mW. Furthermore, the present method for determining an optimum recording power includes at least the step of calculating a normalized gradient g(P), from the equation g(P)= $(m/\Delta m)/(P/\Delta P)$, where $\Delta P$ is an infinitesimal change in the vicinity of recording power P, and $\Delta m$ is an infinitesimal change in the vicinity of signal amplitude m.

## FIG. 1

7 PRINTED LAYER
6 PROTECTIVE LAYER
5 REFLECTIVE LAYER
4 SECOND DIELECTRIC LAYER
3 RECORDING LAYER
2 FIRST DIELECTRIC LAYER
1 SUBSTRATE
8 HARD COAT

**Description**

BACKGROUND

Field

This patent specification relates in general to an optical recording medium, and more particularly to a phase-change recording medium and the methods for optimally initializing and recording such recording media, feasible for carrying out read/write/erase operations at high and multiple recording velocities.

Discussion of the Background

Optical information recording media have recently come into wide use as viable information data storage and archival device of large capacity.

Of the optical storage devices, a phase-change recording medium is now known being capable of implementing repeated read/write/erase operations by means of laser beam irradiation utilizing the phase transition between amorphous and crystalline states. For this type of the media in particular, overwrite operations can be carried out using a single light beam and a relatively simple optical system for readout steps, which is advantageous over the magneto-optical memories that has difficulties in overwriting. The optical recording capability of the phase-change recording medium can therefore be utilized, for example, in rewritable compact discs (CD-RWs) and rewritable digital versatile discs (DVD-RWs).

Phase-change materials for forming such recording medium have attracted much attention recently to implement the aforementioned media capabilities. For example, U.S. Patent No. 3530441 discloses chalcogenide alloys such as Ge-Te, Ge-Te-Sn, Ge-Te-S, Ge-Se-S, Ge-Se-Sb, Ge-As-Se, In-Te, Se-Te and SeAs.

Also disclosed to improve stability and crystallization speed are Ge-Te alloy materials added with Au (Japanese Laid-Open Patent Application No. 61-219692), with Sn and Au (Japanese Laid-Open Patent Application No. 61-270190), or with Pd (Japanese Laid-Open Patent Application No. 62-19490). Further disclosed to improve write/readout characteristics for repeated operations are Ge-Te-Se-Sb and Ge-Te-Sb alloys with specified compositions (Japanese Laid-Open Patent Applications No. 62-73438 and 63-228433).

These alloy materials, however, have not been satisfactory in achieving various characteristics of the rewritable phase-change optical recording medium.

In particular, there remain several problems of great importance yet to be solved to achieve desirable characteristics. This may be achieved by attaining sufficient sensitivity during either writing or erasing operation, preventing the decrease in erasure ratio caused by leftover portions during overwriting steps, and improving the durability of the media properties of either written or non-written portions in the recording medium.

Another recording medium is proposed in Japanese Laid-Open Patent Application No. 63-251290, including a single recording layer with a crystallized state of practically more than ternary composition. By "practically more than ternary" is meant in the disclosure that the alloy system includes at least 90 atomic % of a ternary compound (e.g., $In_3SbTe_2$) in the recording layer. It is also stated in the disclosure that write/erasure characteristics are improved with this alloy composition.

However, the composition still has shortcomings such as erasure ratio of relatively small magnitude and laser power to be reduced for write/erase operations.

In addition, still another recording medium is proposed in Japanese Laid-Open Patent Application No. 1-277338, including $(Sb_aTe_{1-a})_{1-y}M_y$ with $0.4 \leq a \leq 0.7$ and $y \leq 0.2$, in which M includes at least one additive selected from the group consisting Ag, Al, As, Au, Bi, Cu, Ga, Ge, In, Pb, Pt, Se, Si, Sn and Zn.

This alloy system essentially consists of $Sb_2Te_3$, and several medium characteristics with this system is described to have been improved such as, high speed write/erase cycle operations by including a rather excess amount of Sb, and high speed erasure by the addition of M elements. In addition, it is also stated that the erasing ratio is obtained to be relatively large for light beams in the continuous (or DC) mode. However, no description is found in that disclosure with respect to the erasing ratio for overwrite operations.

In this context, it may be noted that erasure leftover portions have been found by the present inventors during erasing experiment on the alloy system, and its recording sensitivity is considered not satisfactory.

In a similar manner, further recording media are proposed including respective recording layers such as one disclosed in Japanese Laid-Open Patent Application No. 60-177446 including $(In_{1-x}Sb_x)_{1-y}M_y$ with $0.55 \leq x \leq 0.80$ and $0 \leq y \leq 0.20$, where M includes at least one kind of element selected from the group consisting Au, Ag, Cu, Pd, Pt, Al, Si, Ge, Ga, Sn, Te, Se and Bi; the other disclosed in Japanese Laid-Open Patent Application No. 63-228433 including an alloy GeTe-$Sb_2Te_3$-Sb(in excess). However, the recording media composed of these alloy systems have not attained sufficient media characteristics such as the recording sensitivity and erasing ratio.

Further, there disclosed are optical recording media provided with respective recording layers including alloy systems such as, a Ge-Te-Sb alloy added with N, described in Japanese Laid-Open Patent Application No. 4-163839; a Te-Ge-Se alloy formed such that at least one of constituent elements thereof is incorporated as a nitride, described in Japanese Laid-Open Patent Application No. 4-52188; and a Te-Ge-Se alloy adsorbed with N, described in Japanese Laid-Open Patent Application No. 4-52189. The optical recording media composed of these alloy systems, however, have not acquired satisfactory characteristics for the recording media.

In spite of numerous alloy materials for forming recording layers of the optical recording media, as described hereinabove, there persist needs to solve several problems of great importance and to thereby acquire desirable media characteristics such as sufficient sensitivity during either writing or erasing operation by preventing the decrease in erasure ratio caused by leftover portions during overwrite steps, also improving durability of the structure and property of recorded and non-recorded portions in the recording medium.

As to the optical media, compact discs (CDs) have come into wide use recently as viable information storage media. Along with the rapid growth of the CDs, another type of compact discs, which are writable only once discs (or CD-R's) have been developed and recently placed into the market. However, since information data once recorded on the CD-R disc cannot be corrected because of its write-once feature mentioned just above, the CD-R disc has a shortcoming, in that the disc has to be abandoned when even one non-correctable error is inputted during the writing steps. Another type of the storage medium has therefore been awaited for, that is capable of obviating the above disadvantage of the CD-R disc.

As an example of such storage media, there may be cited a rewritable compact disc utilizing magneto-optical materials. The magneto-optical disc, however, has drawbacks such as difficulty in overwriting and being incompatible with CD-ROM and CD-R discs. Therefore, a phase-change type recording medium has been actively developed recently toward practical use as one which features disc characteristics favorable to compatibility with the above media, among others.

The research and development results disclosed so far are exemplified on the rewritable phase-change recording media and compact discs incorporating the recording media by Furuya, et al., Proceedings of the 4th Symposium on phase change optical recording (1992) 70; Kanno, et al., Proceedings of the 4th Symposium on phase change optical recording (1992) 76; Kawanishi, et al., Proceedings of the 4th Symposium on phase change optical recording (1992) 82; Handa, et al., Japanese Journal of Applied Physics, Vol. 32 (1993) 5226; Yoneda, et al., Proceedings of the 5th Symposium on phase change optical recording (1993) 9; and Tominaga, et al., Proceedings of the 5th Symposium on phase change optical recording (1993) 5.

These rewritable phase-change recording media, however, have not satisfied overall characteristics, such as the compatibility with CD-ROMs and CD-Rs, write/erase capability, recording sensitivity, repeatability of rewriting and readout operations, and durability during storage. The above noted shortcomings in the media characteristics are considered primarily due to relatively low erasure ratios which are caused by the composition and/or structure of the recording materials previously employed for forming the phase-change recording media.

Accordingly, it is desirable to develop novel recording materials capable of attaining higher erasure ratios and being suitable for more sensitive write/erase operations, to thereby be able to implement phase-change compact discs having improved rewritable capabilities.

In order to find such improved material systems and thereby solve the above noted shortcomings, the present inventors have previously proposed several AgInSbTe recording materials.
These materials are disclosed in Japanese Laid-Open Patent Applications No. 3-240590, 4-78031, 4-123551, 4-232779, 5-345478 and 8-22644.

These mixed alloy systems have been found with excellent sensitivity during either writing or erasing operation, and particularly with large erasure ratios, thereby being advantageous to forming recording layers utilizing the mark-edge recording method.

However, since the AgInSbTe mixed alloy systems have been developed to this date for use in recording media primarily with linear recording speed of 10 m/sec or less, the recording media incorporating these alloy system have drawbacks such as insufficient recording cycle capability for the practical use as the recording media with the recording speed of 10 m/sec or larger.

Since the recording layer is in the amorphous state immediately after the layer formation, the layer has to be subjected to so called initialization process, in which it is crystallized by laser annealing process steps to thereby become crystallized having a high enough reflectivity suitable for data recording. This process of the initialization has a considerable effect on the resulting recording characteristics such as overwrite capability, in particular, of optical recording media incorporating such recording layer.

As to the initialization process of the recording media including phase-change recording materials, several improvements are disclosed in apparatuses and methods for the media initialization.

For example, Japanese Laid-Open Patent Application No. 8-77614 discloses an apparatus devised with a tandem type optical system to implement a uniform, high speed initialization of the phase change optical recording medium. Also described in that disclosure is specified shapes of laser beams to be irradiated onto the recording medium for the initialization.

However, since no description is found on intensities or irradiation energy of the laser beams, recording media with satisfactory recorded signal quality are not considered feasible by that disclosure alone. In addition, neither found is the description on the multiple speed recording and recording characteristics at linear velocity of 4.8 m/sec or larger.

Japanese Laid-Open Patent Application No. 9-73666 discloses an optical information recording medium, and the method and apparatus for forming the medium, in which optically readable marks are provided outside data recording regions on the medium for media ID information be stored for the optical recording medium.

Another optical information recording medium, and the method and apparatus for initializing the medium are disclosed in Japanese Laid-Open Patent Application No. 9-212918, which is characterized by melting at least a portion of the recording layer during the initialization. As to the method and apparatus, the shape of laser beams on the medium during the initialization steps is specified such that the longer axis (i.e., major axis) of either approximated ellipsoidal or rectangular shape thereof be aligned perpendicular to recording tracks, to thereby be able to improve the characteristics of recorded signals. In addition, the layer construction of the recording medium is specified as well in that disclosure.

Although there indicated in the above disclosure is that the improvement in recording characteristics is achieved by melting at least a portion of the recording layer during the initialization, as noted earlier, no description is found on irradiation energy of the laser beams, and the irradiation energy, in turn, is considered to have a considerable effect on the melting process.

As a result, the improvement in recording characteristics, are considered not necessary feasible by this disclosure alone. In addition, neither found is again the description on the multi-speed recording and recording characteristics at linear velocity of 4.8 m/sec or larger.

Japanese Laid-Open Patent Application No. 10-241211 describes on improved initialized characteristics which are achieved by carrying out a layer processing step prior to the initialization during a recording media fabrication. In this disclosure, however, the initialization is made in fact two times, this is considered to result in the decrease in productivity. In addition, no description is found again on the multi-speed recording and recording characteristics at linear velocity of 4.8 m/sec or larger.

A further optical information recording medium, and the method and apparatus for initializing the medium are disclosed in Japanese Laid-Open Patent Application No. 10-289447, in which the axis of beam shape of a laser on a medium under irradiation be aligned other than parallel to recording tracks to result defocused beams.

According to the disclosure with the above alignment, it is effected to decrease the unevenness in reflectivity resulted from the initialization, also in the initialization effect in the layer, which may be caused by the overlap of iterative exposures of the beam irradiation, to thereby prevent for the beams be off the track. However, no description is found on irradiation energy of the laser beams, and neither described is again the description on the multiple speed recording and recording characteristics at linear velocity of 4.8 m/sec or larger.

Since the speed of media recording is ever increasing recently, it is highly desirable for information recording media be devised to have satisfactory recording capabilities at various velocities (i.e., multi-speed recording) exemplified by, for example, CAV (constant angular velocity) recording and excellent signals characteristics after recorded, as well.

As to information data recording into the thus initialized optical recording medium, the determination of optimum recording power with sufficient accuracy is important for its practical usage as well.

Japanese Patent Publication 63-29336 discloses a method for recording information signals on an optical recording medium by a write/readout apparatus, including the steps of scanning energetic beam spots such as those from laser source over the recording medium while irradiating, and modulating the intensity of the spots corresponding to the information signals, to thereby achieve the information recording.

Also disclosed in the publication is the method for determining optimum recording conditions regarding the power, pulse width and so forth, of the recording laser beams, by reading out the signals recorded on the medium, and by subsequently monitoring the width of readout signals and the length of recorded marks.

However, it is considered difficult in practice for the following reasons to always determine optimum conditions by this method even after utilizing information signals actually recorded on the recording medium by conventional write/readout apparatuses.

There described in the disclosure is the method which utilizes the width of readout signals as the representative value and monitors the width (i.e., the difference in signal level between the signals from non-recorded media portions and from recorded portions), whereby the conditions optimum for respective write/readout apparatuses are obtained.

However, the width of readout signals changes not only with recording power, but also with other parameters such as the numerical aperture of the optical system, rim intensity (i.e., spatial intensity distribution of laser beams upon incidence onto a collimator lens), the size and shape of beam spots, and dirty optics and its change with time, and other similar factors.

**EP 1 223 577 A2**

For example, due to the above noted dirty optics, the disparity in optical efficiency generally results as much as 20 % to 40 % among the optical systems in respective write/readout apparatuses. Therefore, it should be noted that the value determined as the optimum recording power may considerably be affected by these parameters.

It has been thus quite difficult in practice to determine the optimum recording power with an enough accuracy (e.g., approximately ± 5%). As a result, difficulties have been encountered in recording media production, for example, in that deviations in the effect of media recording are found among write/readout apparatuses for the same laser power. This necessitates additional minute adjustments of recording power for each apparatus, that causes drawbacks such as, for example, the decrease in the productivity of recording media.

In addition, the determination in advance of the optimum power has not been so effective, because of possible damages caused by excessive laser power during test writing.

That is, the rewritable medium should normally have advantages due to its charactierirstics as the writable media, in which, after determining an appropriate laser power level from test recording made on recording tracks, data recording can be carried out with the thus determined power onto the same recording racks either erase/write or overwrite step, which is in contrast to write once media for which extra tracks exclusively for test writing are needed to determine the power level in advance.

In practice, however, the above advantages have not been so effective, since damages to the recording tracks are often caused by the excessive level of laser power during the test recording. As a result, extra tracks exclusively for test writing have to be provided in practice even for these writable recording media, to thereby result in undue waste of recording tracks, or recording area.

The present inventors have previously proposed an improved method for determining optimum recording power,
in that the power is suitably determined either without being affected by both amplitude of recorded signals, m, and recording power, W, or without being affected by the amplitude alone.

In addition, the optimum recording power can be determined with relative ease in this method with a sufficient accuracy particularly for practical use in write/readout apparatuses devised for the mass production. Further, the addition of the above mentioned extra tracks are alleviated and the accuracy of determined optimum laser power has been increased.

It has been realized by the present inventors, however, further improvements are yet to be made to achieve more efficient information recording, particularly for the range of recording power as high as 15 to 18 mW.

## SUMMARY

Accordingly, it is an object of the present disclosure to provide an optical information recording medium and a method for initializing and recording the recording medium, having most, if not all, of the advantages and features of similar employed optical recording media and methods, while eliminating many of the aforementioned disadvantages.

The following brief description is a synopsis of only selected features and attributes of the present disclosure. A more complete description thereof is found below in the section entitled "Description of the Preferred Embodiments".

The phase-change optical recording medium disclosed herein includes at least a recording layer containing at least materials capable of carrying out read/write/erase operations through phase changes of the materials, and the recording layer essentially consists of Ag, In, Sb and Te, with the proportion in atomic percent of a(Ag): b(In): c(Sb): d (Te), with $0.1 \leq a \leq 7$, $2 \leq b \leq 10$, $64 \leq c \leq 92$ and $5 \leq d \leq 26$, provided that $a + b + c + d \geq 97$.

Alternatively, the recording layer may essentially consist of Ag, In, Sb, Te and Ge, with the proportion in atomic percent of a(Ag): b(In): c(Sb): d(Te): e(Ge), with $0.1 \leq a \leq 7$, $2 \leq b \leq 10$, $64 \leq c \leq 92$, $5 \leq d \leq 26$ and $0.3 \leq e \leq 3$, provided that $a + b + c + d + e \geq 97$. In addition, the layer preferably has a composition satisfying the relation, $88 \leq c + d \leq 98$.

According to another aspect, the optical recording medium is formed incorporating a substrate, and contiguous layers deposited on the substrate in order as follows, a first dielectric layer, a recording layer, a second dielectric layer, a metal/alloy layer, and an ultraviolet light curing resinous layer, in which the recording layer essentially consists of phase change recording materials having one of the compositions described above. These first dielectric layer, recording layer, second dielectric layer and metal/alloy layer are each formed preferably having a thickness ranging from 30 nm to 220 nm, 10 nm to 25 nm, 10 nm to 50 nm, and 70 nm to 250 nm, respectively.

In addition, the recording medium is rewritable at least once at a linear recording velocity ranging from 9 m/sec to 30 m/sec. Furthermore, the metal layer essentially consist of Al and at least one kind of additive with a content ranging from 0.3 weight percent to 2.35 weight percent, which is selected from the group consisting of Ta, Ti, Cr and Si. Also, the metal/alloy layer essentially consist of Ag and at least one kind of additive with a content ranging from 0 to 4 weight percent, which is selected from the group consisting of Au, Pt, Pd, Ru, Ti and Cu.

According to another aspect, a sputtering target for forming a recording layer is disclosed, in which the recording layer is incorporated into an optical recording medium capable of carrying out read/write/erase operations through phase changes of materials therein.

The sputtering target essentially consists of Ag, In, Sb and Te, with the proportion in atomic percent of a(Ag): b(In): c(Sb): d(Te), with $0.1 \leq a \leq 7$, $2 \leq b \leq 10$, $64 \leq c \leq 92$ and $5 \leq d \leq 26$, provided that $a + b + c + d \geq 97$.

Alternatively, the sputtering target may essentially consist of Ag, In, Sb, Te and Ge, with the proportion in atomic percent of a(Ag): b(In): c(Sb): d(Te): e(Ge), with $0.1 \leq a \leq 7$, $2 \leq b \leq 10$, $64 \leq c \leq 92$, $5 \leq d \leq 26$ and $0.3 \leq e \leq 3$, provided that $a + b + c + d + e \geq 97$. In addition, the sputtering target preferably has a composition satisfying the relation, $88 \leq c + d \leq 98$.

According to another aspect, a method is disclosed for initializing a phase-change optical recording medium by irradiating the recording medium with a scanning beam spot emitted from a high power semiconductor laser device. The recording medium is capable of carrying out optically read/write/erase operations of information data.

The energy density input by the beam spot during one period of through scan is equal to, or less than, 1000 $J/m^2$, or alternatively, equal to, or larger than, 600 $J/m^2$. In addition, the scanning speed of beam spot is in the range of 3.5 m/sec to 6.5 m/sec, and the intensity of the emission from the semiconductor laser device is equal to, or greater than 330 mW.

Furthermore, the width of overlapped portion, which is formed as an overlap of irradiated portions, between two neighboring irradiation tracks on the recording medium during two consecutive rotations in initializing steps, is equal to, or less than, 0.5 Wr, where Wr is the width at half maximum of the spatial laser power distribution in the direction perpendicular to scanning direction.

According to another aspect, an apparatus is disclosed being configured to perform at least an initialization operation onto a phase-change optical recording medium by irradiating the recording medium with a scanning beam spot emitted from a high power semiconductor laser device, in which the initialization operation includes at least the steps described above.

According to another aspect, a method is disclosed for carrying out read/write/erase operations of information data on a rewritable phase-change optical recording medium through the phase change induced in a recording layer included in the recording medium by laser beam irradiation, in which the recording layer essentially consists of Ag, In, Sb and Te elements.

The present method for selecting an optimum recording power includes at least the steps of (1) writing a series of information data, as test recording runs, with recording power of laser beam consecutively varied in the range of 15 mW to 18 mW to thereby generate a recorded pattern including low and high reflective portions, (2) reading out signals from the low and high reflective portions on the recording medium to obtain recorded signal amplitude, m, corresponding to the recording power, P, (3) calculating a normalized gradient, g(P), using the equation, $g(P) = (m/\Delta m)/(P/\Delta P)$, where $\Delta P$ is an infinitesimal change in the vicinity of P, and $\Delta m$ is an infinitesimal change in the vicinity of m, (4) determining an optimum recording power, after judging adequacy of the magnitude of the recording power based on thus calculated normalized gradient, g(P), (5) selecting a specific number, S, from the numbers in the range of 0.2 to 2.0 based on the calculated normalized gradient, g(P), (6) obtaining the value of recording power, Ps, which coincide with the specific number, S, presently selected, (7) selecting a specific number, R, based on thus obtained recording power, Ps, from the numbers in the range of 1.0 to 1.7, and (8) multiplying the recording power, Ps, by the specific number, R, whereby an optimum recording power, $P_0$, is obtained.

In addition, these specific numbers, S and R, may be recorded in advance in the optical recording medium, to thereby be utilized to select an optimum recording power under actual media running conditions. For the recording medium, the numbers, S and R, are in the range of $1.2 \leq S \leq 1.4$, and $1.1 \leq R \leq 1.3$, respectively, and the recording medium herein disclosed is recordable at a recording velocity ranging from 4.8 m/sec to 14.0 m/sec.

The present disclosure and features and advantages thereof will be more readily apparent from the following detailed description and appended claims when taken with drawings.

BRIEF DESCRIPTION OF THE DRAWINGS

FIG. 1 is a section view illustrating the optical recording medium according to one embodiment disclosed herein;

FIG. 2 is a schematic diagram illustrating an initialization apparatus according to one embodiment disclosed herein;

FIG. 3 is a schematic diagram illustrating an initialization apparatus according to another embodiment disclosed herein;

FIG. 4 contains a graph illustrating the first 3T land jitter results as a function of initialization power P and scanning speed of initialization head V;

FIG. 5 contains a graph illustrating energy density as a function of initialization power P and scanning speed of initialization head V;

FIG. 6 contains a graph illustrating 3T land jitters after 1000 cycles as a function of initialization power P and scanning speed of initialization head V;

FIG. 7 contains a graph illustrating reflectivity fluctuation ΔRgh as a function of initialization power P and scanning speed of initialization head V;

FIG. 8 contains a graph illustrating the range of suitable P,V values for achieving optimal initialization results;

FIG. 9 illustrates the pulse shape of input light beams of 5T width applied to the phase-change recording medium according to one embodiment disclosed herein;

FIG. 10 illustrates the pulse shape of input light beams applied to the phase-change recording medium of Example 1; and

FIG. 11 is a block diagram illustrating the major parts of the write/readout system according to one embodiment disclosed herein.

DESCRIPTION OF THE PREFERRED EMBODIMENTS

In the detailed description which follows, specific embodiments on information recording media and materials for forming such recording media are described together with the methods for initializing and recording the recording media. It is understood, however, the present disclosure is not limited to these embodiments, and it is appreciated that the materials and methods for optical recording media disclosed herein may also be adaptable to any form of information recording. Other embodiments will be apparent to those skilled in the art upon reading the following description.

The recording medium disclosed herein is characterized by quaternary phase-change recording materials including compositional elements such as Ag, In, Sb and Te, as the major components. The recording materials are found having several characteristics suitable for use in optical recording media, such as excellent sensitivity to, and speed of, recording (i.e., amorphous phase formation) and erasure (crystalline phase formation), and also having desirable erasure ratios.

The phase-change recording materials preferably have the composition specified in general by the relation among the proportion of the above noted compositional elements, Ag, In, Sb and Te, with the proportion in atomic percent of a(Ag): b(In): c(Sb): d(Te), with $0.1 \leq a \leq 7$, $2 \leq b \leq 10$, $64 \leq c \leq 92$ and $5 \leq d \leq 26$, provided that $\alpha + \beta + \gamma + \delta \geq 97$.

Alternatively, the recording materials may preferably have the composition specified by the relation of a(Ag): b(In): c(Sb): d(Te): e(Ge), with $0.1 \leq a \leq 7$, $2 \leq b \leq 10$, $64 \leq c \leq 92$, $5 \leq d \leq 26$ and $0.3 \leq e \leq 3$, provided that $a + b + c + d + e \geq 97$. In addition, particularly in the present disclosure, a further relation may preferably supplemented as $88 < a + b + c + d < 98$.

The results on the composition of the recording layers disclosed herein have been obtained from the emission spectral analysis, while other methods may also be used for the analysis, such as X-ray microanalysis, Rutherford backscattering, Auger analysis, fluorescent X-ray spectroscopy and other similar methods. The results obtained from the latter methods may be used to compare with those from the emission spectral analysis. For the emission spectral analysis, its error of measurements is known in general to be within 5%.

The structure of the materials in the recording layer may be examined by the diffraction method using either X-rays or electron beams. The crystalline state, for example, can be distinguished from the amorphous state using the electron beam diffraction method. This is, the presence of diffraction spots and/or Debye rings in diffraction patterns is generally taken to be indicative of the crystalline state, while halo rings are of the amorphous state. In addition, the diameter of the crystallites may be calculated from the peak width at half maximum of the X-ray diffraction patterns according to the Scherrer's equation.

The nature of chemical bonds of oxides and nitrides included in the recording layer may be analyzed by spectroscopic methods such as, for example, FT-IR and XPS.

Recording layers are formed by sputtering methods using sputtering targets disclosed herein, preferably having a thickness ranging from 10 to 50 nm, more preferably from 12 to 25 nm.

The layer thickness less than 10 nm causes considerable decreases in absorbency and become incapable of functioning as proper recording layers, while difficulties in achieving uniform phase transition result for the thickness larger than 50 nm at high speed recording.

It is known a recording layer suitable for the optical data recording can be formed using a sputtering target, in which two components are included, one SeTe alloy and the other $AgInTe_2$ alloy having a composition of at least in the vicinity of the stoichiometric composition of either chalcopyrite or zincblende. The thus formed recording layer is subsequently subjected to appropriate layer processing such as, for example, initialization steps, whereby a recording layer is completed with desirable recording characteristics such as large erasure ratios and repeated write/erase capabilities.

The crystallite size of the above mentioned $AgInTe_2$ alloy, which has a structure of at least in the vicinity of either chalcopyrite or zincblende structure, can be determined by the X-ray diffraction method. That is, from the peak width at half maximum obtained for the main peak in X-ray diffraction (at diffraction angle of 24.1° for CuKα X-rays having $\lambda = 1.54A$), the crystallites size can be calculated. It is desirable to calibrate using a well defined standard set of the crystallite size in advance to ascertain the accuracy of the determination.

For the AgInTe$_2$ alloy with the crystallite size exceeding 45 nm, stable record/erase operations becomes difficult even after proper initialization process on the recording layer.

In addition, by using Ar sputtering gaseous compositions which include an adjusted amount of N gas of at most 10 mol%, desirable properties of the recording layer can be obtained depending on the N composition, so as to attain appropriate disc characteristics such as linear velocity of rotation and disc layer structure.

The use of the above noted mixed Ar/N gaseous compositions can also yield improved durability in record/erasure operations. The Ar/N gaseous compositions may be prepared either by mixing gaseous constituents in a predetermined mixing ratio prior to the introduction into a sputtering chamber, or by adjusting the proportion of respective incoming gaseous constituents such that a predetermined molar ratio be attained inside the sputtering chamber following the introduction.

The amount of N in the recording layer is preferably at most 5 atomic % to achieve appropriate disc characteristics. In addition to the above noted overwrite characteristics in repeated operations, concrete examples of improved disc characteristics are found on percentage modulation and storage life for the recorded marks (or amorphous marks), among others.

Although the details are yet to be clarified, the mechanism for these effects is considered as follows: The incorporation of N into the recording layer tends to increase the coarseness of the film structure caused by the decrease in layer density and the increase in minute defects. This results in the structural order of the layer be more relaxed than that prior to the N incorporation, which, in turn, tends to suppress the transition from the amorphous state to the crystalline state. As a result, the stability of amorphous marks increases, thereby improving the storage life for the recorded marks. Furthermore, the linear velocity of the transition is controlled by adding appropriate amount of N into the recording layer.

The N elements are preferably incorporated into the recording layer chemically bonded to at least one of Ag, In, Sb and Te elements. When the chemical bond is formed with Te, in particular, such as exemplified by Te-N and Sb-Te-N, pronounced effects can be achieved with the improvement in the number of repeated overwrite cycles.

Such chemical bonds may be analyzed by spectroscopic methods such as, for example, FT-IR and XPS. In FT-IR spectra, for example, the Te-N bond exhibits an absorption peak in the 500-600 cm$^{-1}$ spectral range, while the Sb-Te-N bond has an absorption peak in the 600-650 cm$^{-1}$ range.

In addition, it is effective for the recording layer to incorporate other elements or impurities to further improve media characteristics. For example, these additives are preferably selected from the group consisting of B, N, C, P and Si, as disclosed in Japanese Laid-Open Patent Application No. 4-1488, and another group consisting of O, S, Se, Al, Ti, V, Mn, Fe, Co, Ni, Cu, Zn, Ga, Ge, Sn, Pd, Pt and Au. The addition of Ge elements are particularly effective in improving the durability of recorded marks and the number of overwrite cycles.

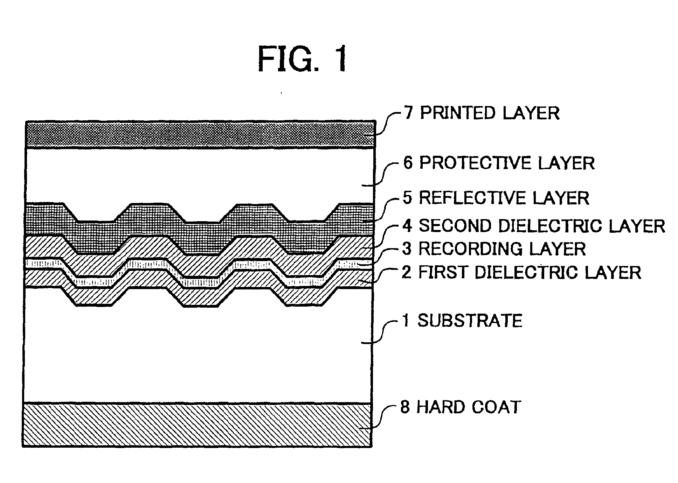

The thus formed recording layer is subsequently incorporated into an optical recording medium which will be described herein below in reference to FIG. 1.

A phase-change optical recording medium disclosed herein preferably includes a supporting substrate 1, and the following layers formed contiguously on the supporting substrate in order as follows: A first dielectric (heat resisting, protective) layer 2, a recording layer 3, a second dielectric (heat resisting, protective) layer 4, a reflective (heat dissipating) layer 5, and an overcoat (upper protective) layer 6. Further, a printed layer 7 and a hard coat layer 8 may additionally be formed on the overcoat layer 6 and the mirror face of the substrate, respectively.

Although both first and second dielectric layers 2,4 need not be formed placing the recording layer 3 therebetween as shown in FIG. 1, the formation of the former layer 2 is preferred in case of the substrate 2 formed of relatively low melting point materials such as polycarbonate, for example.

The supporting substrate 1 is formed of materials preferably enough transparent to light in the wavelength range for use in recording and readout operations of the recording medium.

Suitable materials for forming the substrate 1 include glass, ceramics and resinous materials. Of these materials, resins are preferably employed for its satisfactory transparency and moldability.

Specific examples of the resins include polycarbonate resins, acrylic resins, epoxy resins, polystyrene resins, acrylonitrile-styrene copolymeric resins, polyethylene resins, polypropylene resins, silicone resins, fluororesins, acrylonitrile-butadiene-styrene (ABS) resins and urethane resins. Among these resins, polycarbonate resins and acrylic resins are preferably used for their excellent moldability, optical properties and relatively low costs.

While the substrate 1 is usually of disc-shaped, it may also be of card or sheet-shaped.

In addition, the substrate may be provided with grooves, in general, and the grooves are formed preferably under the following conditions in case for use in rewritable compact disc (CD-Rewritable). That is, the grooves formed to help guide the laser beams during the read/write operations preferably have a width ranging from 0.35 $\mu$m to 0.70 $\mu$m, more preferably from 0.45 $\mu$m to 0.65 $\mu$m; a depth thereof ranging from 15 nm to 60 nm, more preferably from 20 nm to 50 nm.

By implementing these substrate conditions together with the recording material and medium construction described earlier, a rewritable compact disc can be formed with excellent compatibility.

To be more specific, the magnitude of push-pull signals after recording, PPm, is proposed as one of important characteristic values for the compact disc (CD Standard), in which PPm values are required to be in the range between 0.04 and 0.15, preferably between 0.06 and 0.14, and most preferably between 0.08 and 0.12.

It has been quite difficult for phase change rewritable compact discs to satisfy these PPm conditions and all other major requirements for read/write characteristics simultaneously at the linear recording speed of 10 m/sec or greater. However, this becomes feasible with the advent of the phase change recording media disclosed herein, fulfilling the overall characteristics required for the practical rewritable compact discs.

The dielectric (heat resisting, protective) layers are formed primarily consisting of dielectric materials for their suitable thermal and optical properties.

Examples of suitable dielectric materials for forming the dielectric layers include metal oxides such as SiO, $SiO_2$, ZnO, $SnO_2$, $Al_2O_3$, $TiO_2$, $In_2O_3$, MgO and $ZrO_2$; nitrides such as $Si_3N_4$, AlN, TiN, BN and ZrN; sulfides such as ZnS, $In_2S_3$ and $TaS_4$; carbides such as SiC, TaC, $B_4C$, WC, TiC and ZrC; diamond-like carbon, and mixtures thereof.

These materials may be used individually or in combination. In addition, they may further include impurities, where relevant. While the dielectric layers may be formed to have a multilayered structure, their melting temperatures are preferably higher than that of the recording layer.

The first and second dielectric layers 2,4 can be formed by, for example, vacuum evaporation, sputtering, plasma CVD, light assisted CVD, ion plating, or electron beam evaporation, or other similar methods. Of these, the sputtering method is preferably utilized for its excellent productivity and properties of those layers formed.

The materials and thickness for forming respective dielectric layers may be determined independent one another after considering optical and thermal properties.

The first dielectric layer 2 preferably have a thickness ranging from 20 nm to 200 nm, more preferably from 30 nm to 120 nm. When the thickness thereof is smaller than 20 nm, the layer cannot serve as a heat resisting protective layer, while the thickness of larger 200 nm causes several difficulties such as peeling-off at interlayer portions with relative ease and reducing the recording sensitivity.

The thickness of the second dielectric layer 4 preferably ranges from 15 nm to 40 nm, more preferably from 20 nm to 35 nm. When the thickness thereof is smaller than 15 nm, the layer cannot serve as a heat resisting protective layer and result in a decrease in recording sensitivity. In contrast, the thickness of larger 45 nm causes again several difficulties such as peeling-off at interlayer portions with relative ease and reducing the recording sensitivity in repeated recording operations, especially when recorded at a linear velocity as low as from 1.5 to 5.6 m/sec.

In addition, the dielectric layers 2,4 may be formed to have a multilayered structure, as indicated earlier.

The recording layer 3 is formed on top of the thus formed first dielectric layer 2. The quaternary phase-change recording materials including compositional elements such as Ag, In, Sb and Te together with its composition suitable for forming the data recording layer are detailed earlier. Alternatively, the recording layer 3 may be formed of other phase change materials than the AgInSbTe material. Examples of the alternative phase change materials include alloys such as GeTe, GeTeSe, GeTeS, GeSeSb, GeAsSe, InTe, SeTe, SeAs, Ge-Te- (Sn, Au, Pd), GeTeSeSb, GeTeSb, and AgInSbTe.

The composition of these compounds may properly be adjusted to attain optimum recording sensitivity depending on the linear recording velocity.

Furthermore, additional elements or impurities may be incorporated into the compounds to further improve media characteristics. The additional elements are preferably selected from the same group of elements as mentioned earlier for the AgInSbTe compounds together with Ga and Zr, additionally included. It may be noted that the above impurities are selected from those which are not already included as major components in respective recording materials.

The recording layer may be formed by, for example, vacuum evaporation, sputtering, ion plating, CVD, or other similar methods. Of these, the sputtering method is preferably utilized for its excellent productivity and low costs.

Subsequently, the reflective (heat dissipating) layer 5 is formed on top of the second dielectric (heat resisting, protective) layer 4.

Suitable materials for forming the reflective layer 5 include metals such as Al, Au, Ag and Cu and alloys thereof. Of these materials, Al alloys and Ag metal and its alloys are preferably employed for its excellent durability and low costs. These metals and alloys may each be added with impurities, in which Ta, Ti, Cr and Si elements are effective for the Al alloys, while Au, Pt, Pd, Ru, Ti and Cu are suitable for the Ag alloys.

The reflective layer 5 can be formed by, for example, vacuum evaporation, sputtering, plasma CVD, light assisted CVD, ion plating, electron beam evaporation, or other similar methods. In order for the reflective layer 5 to properly serve as a heat dissipating layer, the thickness thereof is preferably ranging from 50 nm to 200 nm, more preferably from 70 nm to 180 nm.

The thickness thereof larger than that above noted cause an excessive heat dissipation to result in the decrease in recording sensitivity, while decrease in the overwrite cycle characteristics is found except recording sensitivity retained for smaller layer thickness.

As suitable properties for the reflective layer material, therefore, high heat conductivity and also high melting point are preferable.

Furthermore, an overcoat (upper protective) layer 6 is preferably formed on top of the reflective layer 5 to serve as an oxidation resistant layer. This layer is generally formed with ultraviolet curing resinous materials which may be disposed by spin coating or dipping method.

The thickness thereof preferably ranges from 7 μm to 15 μm. The layer thickness smaller than 7 μm may result in the increase of C1 errors (or block error rate) after affixing an overlying printed layer, while the thickness larger than 15 μm tend to cause the increase in the internal stress which considerably influences mechanical properties of the recording disc.

In addition, the overcoat layer 6 preferably has a sufficient hardness enough to prevent scratches caused by, for example, wiping the layer surface with a cloth. Further, electrically conductive composition may be incorporated into the overcoat layer, where relevant, to render antistatic and thus prevent dirt from sticking onto the layer surface.

On the overcoat layer 6, at least one of printed layers 7 may be formed, when relevant, to thereby serve as a label. In contrast, a hard coat layer may additionally be formed on the mirror face of the substrate, to thereby increase surface strength against scratches. Examples of the material for use in the printed layer 7 may be selected from the group of conventional photo-curing inks which are printed generally by the screen printing method.

The materials and the method for forming the hard cost layer may be selected from ones similar to those for the protective layer 6. In addition, a couple of recording discs may be adhered with two overcoat layers back to back so as to form a single recording disc.

As electromagnetic radiation and energetic beams useful for initializing, recording, reading-out, or erasing the recording medium disclosed herein, laser light, ultraviolet light, visible light, infrared light or microwave radiation may be utilized. Of these radiation and beams, light beams from a semiconductor laser device is preferably used for its smallness in size and compactness, thereby being suitably incorporated into a drive unit for operating the recording media.

Since the recording layer is in the amorphous state immediately after the layer formation, as described earlier, the layer has to be subjected to so called initialization process, in which the layer is crystallized by laser annealing process steps to thereby become crystallized to yield a high enough reflectivity suitable for data recording. The process of the initialization has a considerable effect on the resultant recording characteristics such as overwrite capability, in particular, of optical recording media incorporating such recording layer.

There will be described herein below the apparatus and process for carrying out the initialization process according to embodiments disclosed herein.

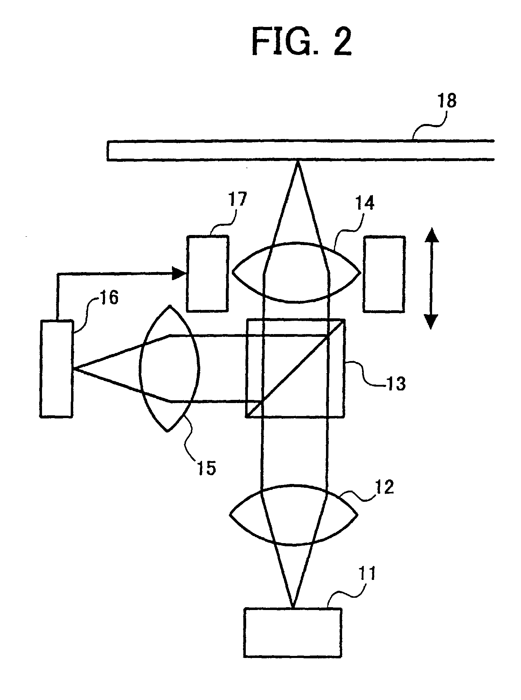

FIG. 2 is a schematic diagram illustrating an initialization apparatus according to one embodiment.

Referring to FIG. 2, the initialization apparatus includes at least a semiconductor laser device 11 as a light source, a collimator lens 12 for collimating laser beams, a beam splitter 13 for dividing reflected beams, an objective lens 14, another collimator lens 15, and an auto-focusing (AF) unit 16 including at least a detector and an actuator.

There utilized as the laser source are a semiconductor laser, a gas laser, and other similar laser devices. Of these devices, a high power semiconductor laser device is preferred for its smallness in size and low in costs.

The output power thereof is in general in the range between 400 to 1000 mW. Among the beam shapes thereof which suitably be selected for use in initialization, either ellipsoidal or rectangular shape in near field pattern may preferably be utilized with the lengths of the major and minor axes ranging from 10 to 500 μm and from 0.5 to 10 μm, respectively.

When the laser beams are aligned such that the longer axis thereof be aligned at least close to perpendicular to recording tracks, there result in the increase in the disc area (or medium area) covered by the laser beams per disc rotation. As a result, the initialization efficiency can be increased, thereby facilitating to reduce initialization time with this alignment of the laser beams.

The output beams of the semiconductor laser device 11 as the light source is collimated through the collimator lens 12, and then focused onto at least in the vicinity of the recording layer included in the medium by the objective lens 14 to be irradiated with radiation energy, whereby data recording is achieved.

Portions of the laser beams are reflected from the disc surface, lead to the beam splitter 13 though the objective lens 14, and directed to the AF unit 16 after being divided by the beam splitter 13, thereby being utilized for establishing proper focus through the movement of the objective lens 14.

The method for establishing and maintaining the focus is carried out by previously known method such as, for example, the knife-edge and astigmatic methods. The unit shown herein above in FIG. 2 is hereinafter referred to as 'initialization head'.

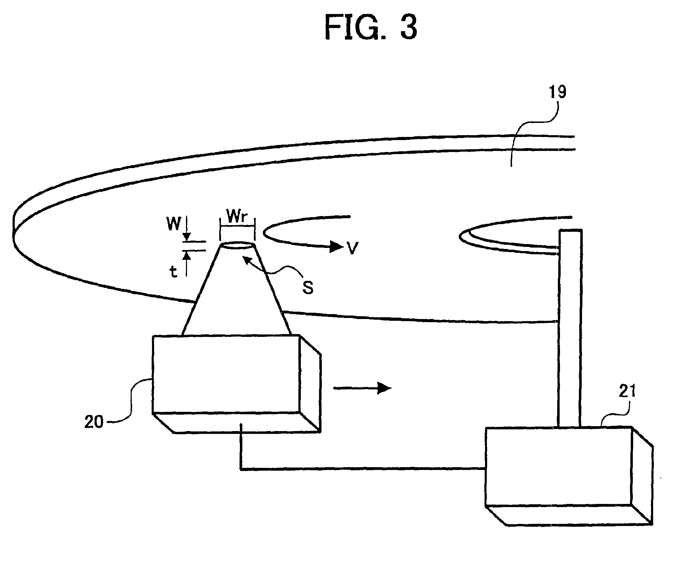

The method for initializing recording media disclosed herein is implemented by scanning the initialization head over the area of recording medium. The detailed conditions of the initialization may be adjusted arbitrarily, and an apparatus therefor is illustrated in FIG. 3 in the case of disc-shaped recording medium.

Referring to FIG. 3, the initialization apparatus according to one embodiment disclosed herein includes at least a spindle mechanism 21 for rotating optical recording medium 19, and initialization head 20 provided with at least with an actuator for displacing the initialization head.

The laser beam scanning is carried out with the thus constructed apparatus, by rotating the optical recording medium 19 by the spindle mechanism 21 and simultaneously displacing the initialization head 20 in the radial direction of the medium. The laser beams are therefore scanned spirally over the area of the recording medium to achieve the initialization.

Since the spindle mechanism 21 and initialization head 20 are constructed to be operable in the interlocked manner, the disc rotation and the movement for displacing the initialization head 20 in the radial direction is also controlled in this manner.

In addition, these rotating and displacing movements are controlled with the above construction such that the speed, at the location of beam irradiation, of the initialization head 20 relative to the rotating medium portion is maintained to be constant, V. As a result, a constant scanning speed is achieved and maintained during medium initialization with laser beam irradiation.

The initialization head 10 may be displaced either from the outer edge to inward of the disc or the other way around during the beam scanning. The initialization is carried out at least over the data recording area on the disc, and may also be made the area therebeyond.

In order for the recording layer be adequately initialized throughout the disc area, a displacement step, d, (or the amount of displacement in the direction perpendicular to the disc tracks) of the initialization head 10, and the width at half maximum, Wr, of the spatial laser power distribution in the direction perpendicular to the disc tracks, preferably satisfy the relation, d < Wr. That is, the displacement step has to be smaller than the width at half maximum of the spatial laser power distribution of the laser device.

In addition, the overlap of irradiated portions have to be further considered. Since such overlapped area portions result in the area irradiated substantially more than once, spatial fluctuation may be created in the initialization effect over the disc area. This spatial fluctuation further results in microscopic reflectivity fluctuation especially at the overlapped portions.

In order to decrease the reflectivity fluctuation, it is preferable for the width of the overlapped portion, Wr - d, and the width at half maximum, Wr, of the spatial laser power distribution satisfy the relation, Wr - d < 0.5 Wr.

The apparatus and process for carrying out the media initialization process disclosed herein are characterized by the energy density to be used therefor, as will be detailed herein below.

The output laser power and scanning speed for the media initialization have to be determined by an energy density input into a recording medium during one scanning period.

The energy density E is expressed by the relation,

$$E = P \cdot V /(S \cdot Wt) = P /(Wr \cdot V),$$

where P is output laser power, V scanning speed, S the area on the medium under irradiation, and Wt and Wr the width of the laser beam in the direction along, and perpendicular to, the scanning direction, respectively.

The energy density value expresses the amount of energy input into the unit area of the recording medium during one scanning period, and this value is therefore directly related to the effect generated on the recording layer by the initialization process.

As the energy density E increases, the amount of heat generated in the medium increases, thereby causing the increase in temperature in the recording layer. As a result, the recording layer can be brought into the stable crystalline state.

However, the energy density E of unduly high causes the following difficulties: When amorphous marks are formed on the thus formed crystalline recording layer through the further irradiation, edge portions of the marks become more highly crystallized by the heat from the above-mentioned irradiation.

As a result, when lands are subsequently overwritten on top of the recorded marks, these marks become so stabilized that they can not be completely erased, to thereby result in the deterioration in jitters during the first overwrite step.

The upper limit of the energy density E max, which assures satisfactory first overwrite characteristics, is obtained as E max = 1000 J/m$^2$. Accordingly, it is necessary for the recording medium disclosed herein be initialized at least under the condition of the energy densities of E ≤ E max.

In this context, it is noted E values higher than E max have been generally adopted previously for media initialization. For example, the E values used in practice are in the range of 1100 to 1400 J/m$^2$ in the case of CD-RW discs having linear recording velocities of 1.2 to 4.8 m/sec. The E values for the initialization as high as the present example are considered to cause the above noted deterioration in jitters during the first overwrite step, especially at high linear velocities.

For unduly low E values, in contrast, the amount of heat input into the recording layer is insufficient to achieve satisfactory crystallization results. Many portions therefore remain as non-crystallized and the media reflectivity also remains low.

When the thus formed (or prematurely initialized) medium is subjected to iterative overwrite steps, the crystallization of the premature media portions are accelerated with the increase in the number of overwrite cycles, whereby a considerable change in reflectivity results compared with its initial value.

As a result, recorded signal qualities following the large number of overwrite cycles are also considerably changed from initial qualities, thereby resulting in jitter value deterioration after a large number of recording cycles, that is disadvantageous in use for practical recording media.

The lower limit of the energy density, E min, which assures to alleviate the jitters deterioration after the large number of overwrite cycles, is obtained as E min = 600 J/m$^2$.

Accordingly, it is preferable for the recording medium disclosed herein be initialized at least under the condition of the energy densities of E min $\leq$ E.

The scanning speed, V, has a large effects on unevenness in reflectivity resulted from the initialization. For unduly high V values, portions of the recording medium become to be left as non-crystallized (or prematurely crystallized) more often, which is resulted at least partially from the failure in tracking movements by focus servo unit, which is, in turn, caused by the high V values. This difference in crystallization has effects on the reflectivity, as indicated earlier, thereby resulting in spatial fluctuation in reflectivity and further causing possible failure in tracking.

For unduly low V values, in contrast, the beam irradiation time is prolonged and the recording and dielectric layers in the medium tend to be affected more often by heat damages. As a result, the deterioration in recording characteristics such as jitters, in particular, is caused after a large number of overwrite cycles.

Accordingly, it is preferable for the recording medium disclosed herein be initialized at least under the conditions with respect to the scanning speed V, specified as V min $\leq$ V $\leq$ V max, with V min = 3.5 m/sec and V max = 6.5 m/sec.

As to information recording into the thus initialized optical recording medium, the determination of optimum recording power with sufficient accuracy is important for its practical usage as well.

In addition, the use of a high power laser is considered to facilitate to improve the efficiency of record/ readout operations for recording media. The present inventors rigorously examined the effect of the high power laser beams on the recording medium to thereby find optimum conditions of the laser power through experimentation, which will be detailed herein below.

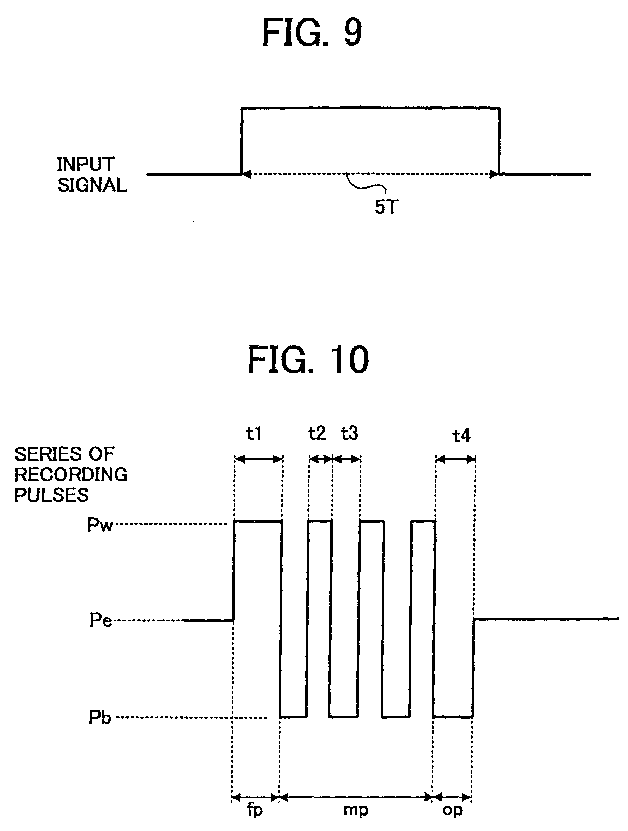

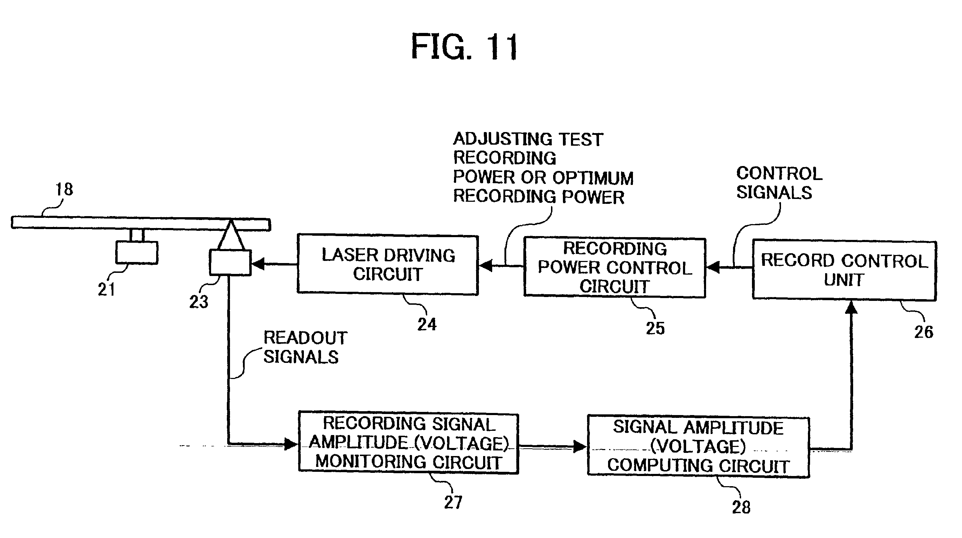

FIG. 9 illustrates the pulse shape of input light beams of 5T width applied to the phase-change recording medium according to the embodiment disclosed herein, FIG. 10 illustrates the pulse shape of input light beams applied to the phase-change recording medium of Example 1, and FIG. 11 is a block diagram illustrating the major units of the write/readout system disclosed herein.

Referring now to FIG. 11, the write/readout system disclosed herein is configured to carry out write/readout operations of information data onto an optical recording medium 18, as follows: Rotating the recording medium 18 including a phase-change optical recording disc by a driving mechanism 21 equipped with a spindle motor, activating a light source including a semiconductor laser device by a laser driving circuit 24 used as a light source driving unit, focusing laser beams onto the optical recording medium 18 by an optical system (not shown), irradiating and thereby inducing the phase transition in the recording layer, and receiving light beams reflected from the recording medium 18 with an optical pickup 23, whereby the write/readout operations onto the optical recording medium 18 are achieved.

As described above, the write/readout system enables to carry out rewriting as well as the write/readout operations of information data onto an optical recording medium 1 by inducing the phase transition in the recording layer through the laser beam irradiation onto the optical recording medium. In addition, the write/readout system is also provided with a plurality of additional units such as, for example, one for modulating information data signals to be recorded by a modulation unit and the other for recording the signals into the recording medium by the write/readout pickup.

This recording unit including the optical pickup writes the information data in terms of the width of recorded 'marks', that is generally referred to as the pulse width modulation (PWM) method. Also, data signals to be recorded are modulated through the modulation unit using clock signals according to either the eight-to-four modulation (EFM) method or modified methods thereof, which are effectively utilized in the data recording for rewritable compact discs, for example.

In data recording into the phase-change recording medium, a "1" signal (i.e., 1 in binary) is made, in general, by forming amorphous portions in the recording layer of the recording medium, which is carried out, in turn, by elevating temperature of the recording layer portion higher than its melting point and subsequently lowering the temperature at a rate large enough for forming the amorphous phase.

Referring to FIG. 10, the data recording can be achieved using a series of laser pulses exposed to the recording medium. Namely, the pulse fp raises the temperature of recording layer portion higher than its melting point to thereby form the front portion of the recorded mark, the pulse mp retains the thus raised temperature to thereby form the middle portion of the recorded mark, and the pulse op lowers the temperature of recording layer portion to thereby form the rear portion of the recorded mark.

The amount of beam irradiation onto the recording medium varies with the linear velocity of the rotating recording medium to thereby change the speed of the above-mentioned raising and lowering the temperature of the recording layer portions. Therefore, the speeds of raising and subsequent lowering the temperature of recording layer portions can appropriately be adjusted by varying the linear velocity of the rotating recording medium.

Further, the information pertinent to recorded data by the PWM method is placed at the edge portions of the recorded marks. Therefore, in order to prevent either smearing at the boundary between recorded and non-recorded portions on the recording layer, or undue erasing caused by the crystallization of the amorphous recorded portions, it is important to prevent undesirable heating of the portions other than those to be recorded.

This smearing prevention, or the distinction between the portions to be recorded and to be retained at lower ordinary temperature, may be achieved by suppressing both undue heat generation at the recording layer portions and controlling heat conduction in the recording layer. By achieving the distinction between the recorded and non-recorded portions with the above noted measures, excellent information data signals with reduced jitter values can be obtained.

Having generally described the present disclosure, the following examples are provided further to illustrate preferred embodiments. This is intended to be illustrative but not to be limiting to the materials, apparatuses or methods described herein.

In addition, Examples 1 through 23 and Comparative Examples 1 through 11 primarily illustrate recording materials and their compositions for forming phase change recording media, while Examples 24 through 26 illustrate the methods and processes for implementing initialization and recording processes on the recording media.

EXAMPLES

EXAMPLES 1 through 10, and COMPARATIVE EXAMPLES 1 through 5

A plurality of phase-change recording media were formed, using sputtering targets, including constituent layers, which will be detailed herein below.

The materials composition of sputtering targets used for the layer deposition are given in Table 1-1. The composition of the layers formed by the deposition are given in respective columns in Table 1-2. The compositions are given in both tables in atomic %.

A phase-change recording medium was first fabricated on a polycarbonate (PC) substrate of 1.2 mm thickness, which was provided with guide tracks of a track pitch of 1.6 $\mu$m formed wit grooves having a depth of approximately 30 nm and a width of approximately 0.6 $\mu$m.

The following constituent layers were subsequently formed on the PC substrate in order as follows by sputtering deposition technique using respective sputtering targets: A first dielectric layer of $SiO_2 \cdot ZnS$ with a thickness of approximately 80 nm, a recording layer of approximately 18 nm thickness, a second dielectric layer of $SiO_2 \cdot ZnS$ with a thickness of approximately 32 nm, a reflective/ heat dissipating layer of Al alloy containing 1.5 wt % of Ti with a thickness of approximately 160 nm, and a coated layer of UV curing resin with a thickness of approximately 10 $\mu$m, whereby a recording medium was formed.

The sputtering deposition of the recording layer was carried out in Ar gas flow of 10 sccm under $3 \times 10^{-3}$ Torr pressure with RF power of 500 W. In a similar manner, further phase-change recording media were subsequently formed.

The thus formed recording media were then subjected to data recording process and characteristic measurements. During the measurements, linear velocities for the data recording suitable for respective recording media were selected ranging from 9 m/sec to 30 m/sec.

As to the signal recording, the EFM method was utilized irradiating with multi-pulsed laser beams during recording. The optical pickup unit presently used had an objective lens of an aperture of NA 0.5 and a semiconductor laser with the emission of 780 nm in wavelength.

Results obtained from the measurements are shown in Table 1-2 on the reflectivity and the number of overwrite cycles for respective recording media. It is added the '$\times$' mark in the overwrite cycle column indicates that an overwrite could not be achieved even though the first recording was feasible.

From the results in Table 1-2 it is indicated excellent disc characteristics are obtained for recording layer compositions of a(Ag):b(In):c(Sb):d(Te): e(Ge), with $0.1 \leq a \leq 7$, $2 \leq b \leq 10$, $64 \leq c \leq 92$, $5 \leq d \leq 26$ and $0.3 \leq e \leq 3$, where a,b,c,d and e are the content (atom %) of Ag, In, Sb, Te and Ge, respectively.

It is also indicated from the results in Comparative Examples 3 and 5 that the reflectivity value was obtained to be 14% or less, for the content, c(Sb)+ d(Te), of 88 atom % or smaller, whereby the readout compatibility with CD-ROM drive was decreased and iterative recording cycle capability was deteriorated.

In addition, for the content, c(Sb)+ d(Te), of 93 atom % or larger, as in Comparative Example 2, the reflectivity becomes too high, whereby readout errors increased since signal amplitudes of sufficiently large magnitude could not be obtained.

Further, on the recording medium with the content as in Comparative Examples 4, 6 and 7, the media overwrite could not be achieved at the linear recording velocity of 9 m/sec.

It may be added herein that the sputtering targets used for forming the above recording layers of Examples 1 through 10 and Comparative Examples 1 through 5, were prepared respectively first by melting raw constituent materials, then cooling to be. solidified, crushing or milling, and subsequently sintering.

Table 1-1

| | Sputtering Target Composition | | | | |
|---|---|---|---|---|---|
| | Ag | In | Sb | Te | Ge |
| Example 1 | 1.0 | 9.0 | 66.0 | 24.0 | 0.0 |
| Ex. 2 | 2.0 | 7.0 | 77.0 | 14.0 | 0.0 |
| Ex. 3 | 7.0 | 4.5 | 68.5 | 20.0 | 0.0 |
| Ex. 4 | 0.5 | 5.5 | 81.5 | 12.5 | 0.0 |
| Ex. 5 | 0.5 | 2.5 | 92.0 | 5.0 | 0.0 |
| Ex. 6 | 1.5 | 9.0 | 67.5 | 22.0 | 0.0 |
| Ex. 7 | 1.0 | 6.5 | 74.5 | 18.0 | 0.0 |
| Ex. 8 | 1.0 | 7.0 | 70.0 | 21.0 | 1.0 |
| Ex. 9 | 0.5 | 7.5 | 65.0 | 25.0 | 2.0 |
| Ex. 10 | 3.0 | 5.0 | 65.0 | 24.0 | 3.0 |
| Comparative Example 1 | 7.0 | 6.0 | 63.0 | 24.0 | 0.0 |
| Com. Ex. 2 | 2.0 | 1.0 | 93.0 | 4.0 | 0.0 |
| Com. Ex. 3 | 3.0 | 11.0 | 66.0 | 20.0 | 0.0 |
| Com. Ex. 4 | 1.0 | 7.5 | 63.5 | 28.0 | 0.0 |
| Com. Ex. 5 | 1.0 | 7.6 | 63.0 | 22.5 | 6.0 |
| Com. Ex. 6 | 4.5 | 5.5 | 62.5 | 27.5 | 0.0 |
| Com. Ex. 7 | 5.5 | 4.0 | 63.0 | 26.5 | 1.0 |

Table 1-2

| | Layer Composition | | | | | Characteristics | |
|---|---|---|---|---|---|---|---|
| | Ag | In | Sb | Te | Ge | Reflectivity (%) | Overwrite cycles |
| Example 1 | 0.9 | 9.1 | 66.2 | 23.8 | 0.0 | 16 | 8000 |
| Ex. 2 | 2.1 | 6.9 | 77.1 | 13.9 | 0.0 | 17 | 5000 |
| Ex. 3 | 7.1 | 4.6 | 68.4 | 19.9 | 0.0 | 15 | 3000 |
| Ex. 4 | 0.6 | 5.5 | 81.6 | 12.5 | 0.0 | 20 | 4000 |
| Ex. 5 | 0.6 | 2.4 | 92.1 | 4.9 | 0.0 | 22 | 5000 |
| Ex. 6 | 1.5 | 9.1 | 67.6 | 21.8 | 0.0 | 15 | 8000 |
| Ex. 7 | 1.1 | 6.6 | 74.4 | 17.9 | 0.0 | 18 | 6000 |
| Ex. 8 | 0.9 | 7.1 | 70.0 | 20.1 | 0.9 | 17 | 4000 |
| Ex. 9 | 0.6 | 7.6 | 64.9 | 24.9 | 2.0 | 16 | 6000 |
| Ex. 10 | 3.1 | 4.9 | 64.8 | 24.1 | 3.1 | 15 | 7000 |
| Com. Ex. 1 | 6.9 | 6.1 | 62.9 | 24.1 | 0.0 | 13 | 300 |

Table 1-2   (continued)

| | Layer Composition | | | | | Characteristics | |
|---|---|---|---|---|---|---|---|
| | Ag | In | Sb | Te | Ge | Reflectivity (%) | Overwrite cycles |
| Com. Ex. 2 | 2.0 | 1.1 | 92.9 | 4.0 | 0.0 | 22 | 500 |
| Com. Ex. 3 | 2.9 | 11.2 | 66.1 | 19.8 | 0.0 | 12 | 600 |
| Com. Ex. 4 | 1.1 | 7.4 | 63.4 | 28.1 | 0.0 | 17 | × |
| Com. Ex. 5 | 1.0 | 7.6 | 63.0 | 22.4 | 6.0 | 13 | 200 |
| Com. Ex. 6 | 4.4 | 5.6 | 62.4 | 27.6 | 0.0 | 16 | × |
| Com. Ex. 7 | 5.4 | 4.1 | 62.9 | 26.6 | 1.0 | 15 | × |

EXAMPLE 11

Several phase-change recording media were formed each including recording layers which were deposited using the sputtering target of Example 1. In addition, the sputtering deposition of respective recording layers was carried out in Ar gas atmosphere mixed with 0, 6, 10 or 15 mol % of gaseous nitrogen.

The composition of the thus formed recording layers was subsequently obtained. In addition, the recording layers were each incorporated into recording media and the overwrite characteristics of these media were also measured. The results from these measurements on the recording layer composition and overwrite cycle number are shown in Table 2.

Table 2

| N2/(Ar+N2) (mol %) | Content (atom %) | | | | | Overwrite cycles |
|---|---|---|---|---|---|---|
| | Ag | In | Sb | Te | N | |
| 0 | 2.1 | 6.9 | 77.1 | 23.9 | 0 | 5000 |
| 6.0 | 1.7 | 6.6 | 76.3 | 23.4 | 2.0 | 4000 |
| 10.0 | 1.5 | 6.4 | 75.2 | 22.9 | 4.0 | 800 |
| 15.0 | 1.4 | 6.3 | 74.7 | 22.6 | 5.0 | 200 |

It is clearly shown from the results included in Table 2 that the number of feasible overwrite cycles sharply decreases in nitrogen contents in excess of 10 mol %.

EXAMPLES 12 through 23, and COMPARATIVE EXAMPLES 8 through 11

Several phase-change recording media were formed using the sputtering target of Example 1 in a similar manner to Examples 1 through 10 and Comparative Examples 1 through 5.

The recording media each include the following layers deposited on a polycarbonate substrate of 1.2 millimeter thickness, such as a first dielectric layer of $SiO_2 \cdot ZnS$ with a thickness of approximately 90 nm, a recording layer of approximately 18 nm thickness, a second dielectric layer of $SiO_2 \cdot ZnS$ with a thickness of approximately 34 nm, and a reflective/ heat dissipating layer of approximately 160 nm thickness. The reflective/ heat dissipating layers for forming respective recording media were each formed herein with metal or alloy layers having the composition shown in respective columns in Table 3.

When the thus formed recording media were subsequently subjected to the measurements on reflectivity, overwrite cycle number and storage durability, the results were obtained as shown in Table 3. For the storage durability, the measurements were made at 80 °C and relative humidity of 85%, and the mark '×' in Table 3 indicates that the increase in errors was found after 300 hours in storage.

Table 3

| | Reflective layer (atom %) | Reflectivity (%) | Overwrite cycles | Storage durability |
|---|---|---|---|---|
| Ex. 12 | A199.5Ti0.5 | 19 | 2000 | ○ |

Table 3   (continued)

|  | Reflective layer (atom %) | Reflectivity (%) | Overwrite cycles | Storage durability |
|---|---|---|---|---|
| Ex. 13 | A197.5Ti2.5 | 17 | 3000 | ○ |
| Ex. 14 | A198.5Ta1.5 | 18 | 3000 | ○ |
| Ex. 15 | A198.5Cr1.5 | 17 | 2500 | ○ |
| Ex. 16 | A198.5Si1.5 | 19 | 1500 | ○ |
| Ex. 17 | A198.5Ti1.0Ta0.5 | 18 | 3000 | ○ |
| Ex. 18 | Ag100 | 20 | 3000 | ○ |
| Ex. 19 | Ag98Pd2 | 18 | 4000 | ○ |
| Ex. 20 | Ag98Cu2 | 19 | 3000 | ○ |
| Ex. 21 | Ag98Au2 | 19 | 5000 | ○ |
| Ex. 22 | Ag98Pt2 | 19 | 4000 | ○ |
| Ex. 23 | Ag96Pd2Cu2 | 17 | 3000 | ○ |
| Ex. 24 | Ag98Ru2 | 18 | 4000 | ○ |
| Ex. 25 | Ag98Ti2 | 19 | 5000 | ○ |
| Com. Ex. 8 | A195Ti5 | 14 | 200 | ○ |
| Com. Ex. 9 | A199Mg1 | 18 | 100 | × |
| Com. Ex. 10 | A198.5Cu1.5 | 14 | 300 | × |
| Com. Ex. 11 | Ag94Pd6 | 13 | 200 | ○ |

It is shown from the results included in Table 3 that (1) reflective/ heat dissipating layers each essentially consisting of Al yield satisfactory media characteristics, when at least one kind of element selected from the group consisting of Ta, Ti, Cr and Si is included therein with its content ranging between 0.3 to 2.5 wt %, and (2) the metal or alloy layers as reflective/ heat dissipating layer each essentially consisting of Ag exhibit excellent overwrite characteristics and storage durability, when at least one kind of element selected from the group consisting of Au, Pt, Pd, Ru, Ti and Cu is included therein with its content ranging between 0 to 4 weight percent.

EXAMPLE 24        II

In order to examine closely initialization process steps and conditions therefor, a CD-RW recording medium was formed.

As illustrated in FIG. 1, this recording medium includes at least a polycarbonate substrate provided with guide tracks of a continuos spiral groove for use in CD-RW discs, and constituent layers formed thereon in order as follows: A first dielectric layer, a recording layer, a second dielectric layer, a reflective layer, and a protective layer.

The first and second dielectric layers were deposited by PF sputtering using sputtering targets of $SiO_2 \cdot ZnS$ composition, and the recording layer was formed by DC sputtering using a sputtering target of AgInSbTe alloy composition. In addition, the reflective layer was formed by DC sputtering using a sputtering target of Al and Ti, as major components.

The first dielectric layer had a thickness of 80 nm, recording layer 20 nm, second dielectric layer 30 nm, the reflective layer, and protective layer 150 nm, respectively.

By spin coating a layer of UV curing resinous material further on the recording medium, and hardening by UV irradiation, the formation of recording medium was completed.

This recording medium was subsequently subjected to initialization process steps using an initialization apparatus equipped with an initialization head operated under the following conditions:

$\lambda$ = 810 nm in laser wavelength for initialization,
$R_r$ = 100 µm for the length of laser beam along the radial direction (or $W_r$ along the major axis),
$R_t$ = 1.0 µm along the tangential direction, and
d = 60 µm for distance of head displacement.

The conditions of medium initialization were shown in Table 4. There found for the recording medium is auto-focusing was not feasible with an initialization power of less than 330 mW, whereby the media initialization was unfeasible.

Also found is that the CD-RW recording media formed as above have satisfactory media characteristics as high speed CD-RW discs capable of carrying out read/write/erase operations according to Orange Book specification (Part III, Vol. 2) at linear recording velocities ranging CD4× to CD10× speed.

Subsequently, data recording steps were carried out onto the initialized recording media according to the Orange Book specification, in which Spin Tester DDU1000 from PulseTech Co. was used as a CD-RW measurement apparatus equipped with an optical pickup unit under the following conditions:

$\lambda$ = 795 nm in laser wavelength for recording,
NA = 0.5,
Linear recording velocity = 12.0 m/sec (CD10×), and
Coding : EFM.

In addition, for the recording, the beam power was used ranging from 19 mW to 21 mW again according to the Orange Book specification, and the results on first direct overwrite (DOW 1) and direct overwrite after 1000 cycles (DOW1000) were primarily obtained. The recorded signals were then readout with the Spin Tester DDU1000 and, 3T land jitters were measured. The results obtained on the readout signals are shown in Table 4.

Table 4

| Initialization conditions | | | Characteristics of recorded signals | | | |
|---|---|---|---|---|---|---|
| V (m/sec) | P (mW) | E (J/m$^2$) | Initial 3T LJ | DOW 1 3T LJ | DOW 1000 3T LJ | $\Delta$Rgh |
| 3 | 330 | 1100 | 20.2 | 37.4 | 35.8 | 0.04 |
| 3 | 385 | 1283 | 19.9 | 42.8 | 38.5 | 0.04 |
| 3 | 440 | 1467 | 20.1 | 49.5 | 42.2 | 0.03 |
| 3 | 495 | 1650 | 21.2 | 54.9 | 44.5 | 0.04 |
| 3 | 550 | 1833 | 21.5 | 61.8 | 46.5 | 0.04 |
| 4 | 330 | 825 | 21.3 | 25.3 | 26.0 | 0.06 |
| 4 | 385 | 963 | 20.9 | 28.2 | 27.3 | 0.06 |
| 4 | 440 | 1100 | 20.0 | 35.8 | 30.0 | 0.05 |
| 4 | 495 | 1238 | 18.8 | 46.5 | 32.2 | 0.05 |
| 4 | 550 | 1375 | 18.5 | 55.3 | 34.4 | 0.04 |
| 5 | 330 | 660 | 22.2 | 24.9 | 27.7 | 0.08 |
| 5 | 385 | 770 | 21.5 | 23.8 | 28.3 | 0.07 |
| 5 | 440 | 880 | 22.2 | 25.5 | 26.6 | 0.05 |
| 5 | 495 | 990 | 23.1 | 28.1 | 27.2 | 0.05 |
| 5 | 550 | 1100 | 22.2 | 36.7 | 28.9 | 0.04 |
| 6 | 330 | 550 | 27.2 | 27.8 | 24.3 | 0.12 |
| 6 | 385 | 642 | 24.1 | 26.2 | 25.5 | 0.10 |
| 6 | 440 | 733 | 24.0 | 24.7 | 27.3 | 0.08 |
| 6 | 495 | 825 | 23.1 | 23.9 | 27.5 | 0.07 |
| 6 | 550 | 917 | 23.2 | 25.1 | 28.8 | 0.07 |
| 7 | 330 | 471 | 30.2 | 32.2 | 27.2 | 0.45 |
| 7 | 385 | 550 | 27.1 | 28.1 | 27.5 | 0.43 |

Table 4   (continued)

| Initialization conditions | | | Characteristics of recorded signals | | | |
|---|---|---|---|---|---|---|
| V (m/sec) | P (mW) | E $(J/m^2)$ | Initial 3T LJ | DOW 1 3T LJ | DOW 1000 3T LJ | $\Delta$Rgh |
| 7 | 440 | 629 | 25.2 | 25.9 | 28.2 | 0.32 |
| 7 | 495 | 707 | 22.1 | 24.8 | 27.8 | 0.30 |
| 7 | 550 | 786 | 22.2 | 23.6 | 28.3 | 0.22 |
| DOW: Direct Overwrite,        LJ: Land Jitter | | | | | | |

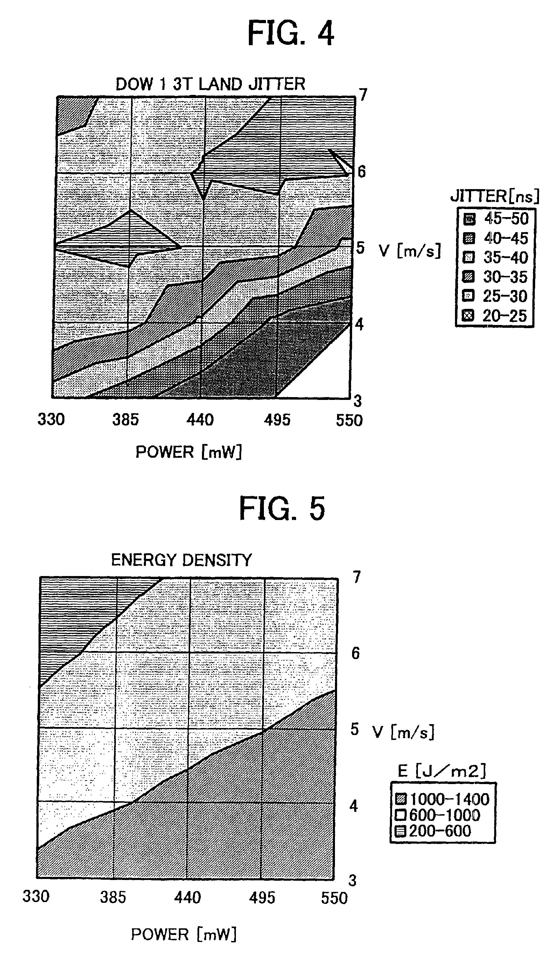

The 3T land jitters were measured with varying initialization power P and scanning speed of the initialization head V, and the results from the measurements are shown also in FIG. 4. It is indicated from the results that the jitters increase with the decrease in P and V. At the same time, the magnitude of energy density E is plotted as a function of P and V in FIG. 5.

When these values shown in FIGS. 4 and 5 are compared, it is found DOW 1 jitters tend to increase with decreasing energy density E. Also found is the range of the E value, E > 1000 $J/m^2$, for which jitters exceed 35 nsec that is specified as a standardized jitter value in the Orange Book.

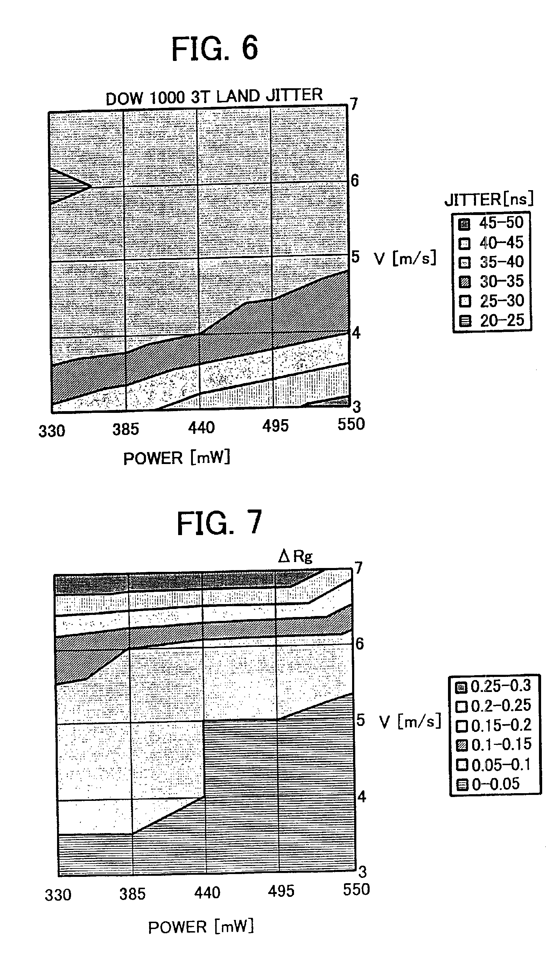

Similarly, 3T land jitters after 1000 cycles of direct overwrite (DOW1000) were measured with varying initialization power P and scanning speed of the initialization head V, and the results from the measurements are shown also in FIG. 6.

When the values shown in FIGS. 6 are compared with those in FIG. 5, it is found the DOW 1000 3T land jitters tend to increase with decreasing energy density E. Also found is the range of the E value, E < 600 $J/m^2$, for which jitters exceed again 35 nsec that is specified in the Orange Book.

As a result, it is indicated satisfactory values for both DOW1 and DOW1000 3T land jitters are obtained for E values in the range of 600 $J/m^2 \leq E \leq 1000$ $J/m^2$, whereby CD-RW discs can be prepared with excellent overwrite characteristics.

Furthermore, as shown also in Table 4, DOW1000 3T land jitters remain relatively high for the scanning speed of 3 m/sec regardless P values, and the overwrite characteristics are found to be able be improved by satisfying the relation, V > 3.5 m/sec.

The change in disc reflectivity, $\Delta$Rgh, is also obtained at the time immediately after the initialization and prior to recording as follows. Namely, reflectivity values of the disc reflectivity, Rgh, were measured over the disc area prior to recording, to thereby yield several reflectivity values such as Rmax, Rmin and Ravg for its maximum, minimum, and average, respectively.

The change in disc reflectivity, $\Delta$Rgh, is then calculated by the equation, $\Delta$Rgh=(Rmax-Rmin)/Ravg. Therefore, as the fluctuation in disc reflectivity over the disc area increases, the change in disc reflectivity or reflectivity fluctuation, $\Delta$Rgh, increases. The $\Delta$Rgh values were measured with varying initialization power P and scanning speed of the initialization head V, and the results from the measurements are shown in FIG. 7.

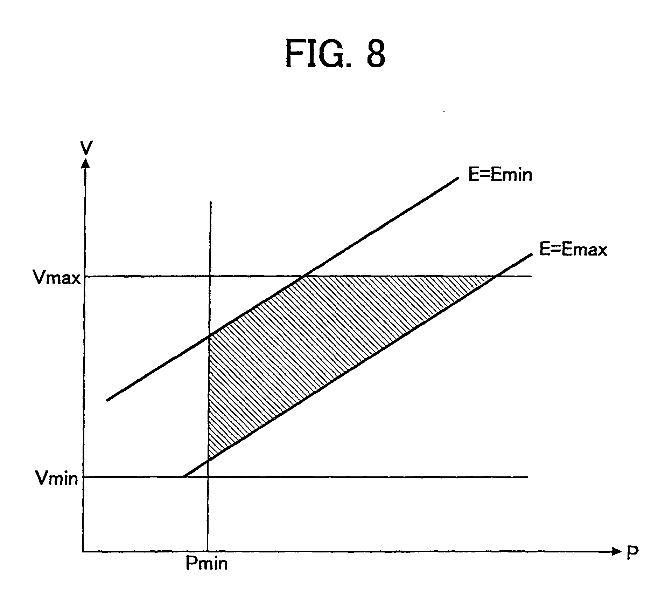

Since the reflectivity fluctuation $\Delta$Rgh exceeding 0.1 increases tracking error signals, failure in precise tracking such as off-tracking may be caused. This difficulty is alleviated by satisfying the relation with the scanning speed V, V $\geq$ 3.5 m/sec, thereby decreasing the fluctuation. As a result, the range of suitable P,V values corresponding to the above noted results is shown with as the shaded area in FIG. 8.

EXAMPLE 25

In order to obtain an optimum recording power, recording process steps were carried out onto a phase-change optical recording medium.

The recording medium was prepared including at least the following layers which were formed in order as follows: A first dielectric layer of $SiO_2 \cdot ZnS$ with a thickness of approximately 90 nm, an AgInSbTe recording layer of approximately 18 nm thickness, a second dielectric layer of $SiO_2 \cdot ZnS$ with a thickness of approximately 32 nm, and an Al alloy layer of approximately 160 nm thickness.

The thus formed recording medium was subsequently subjected to data recording with linear recording velocity of 12.0 m/sec by means of an optical pickup unit having an aperture of NA 0.5 and laser emission of 790 nm in wavelength. In addition, the signals generated after the EFM method were input for data recording.

From the results in FIG. 10, the satisfactory values were found as S = 1.25, R = 1.20, thereby leading to Ps = 18 mW. As a result, the optimum was obtained as $P_0$ = 21.6 mW.

<u>EXAMPLE 26</u>

In order to further obtain an optimum recording power, recording process steps were carried out onto a phase-change optical recording medium.

The recording medium was prepared in a similar manner to that of Example 25. In addition, information on S and R values, corresponding to the above noted relations S = 1.25 and R = 1.20, are recorded in advance in the recording medium.

The thus recorded information is subsequently readout to be utilized as the parameters for selecting an optimum recording power. Using the above noted parameters, the optimum was then found as $P_0$ = 21.8 mW. In addition, iterative recording cycle steps were carried out with this recording power, whereby the recording was achieved with sufficient stability without deteriorating the readout signal quality.

The process steps set forth in the present description on the constituent layer deposition and various recording media measurements may be implemented using a conventional general purpose microprocessors, programmed according to the teachings in the present specification, as will be appreciated to those skilled in the relevant arts. Appropriate software coding can readily be prepared by skilled programmers based on the teachings of the present disclosure, as will also be apparent to those skilled in the relevant arts.

The present invention thus include also a computer-based product which may be hosted on a storage medium, and include instructions which can be used to program a microprocessor to perform a process in accordance with the present disclosure.

This storage medium can include, but not limited to, any type of disc including floppy discs, optical discs, CD-ROMs, magneto-optical discs, ROMs, RAMs, EPROMs, EEPROMs, flash memory, magnetic or optical cards, or any type of media suitable for storing electronic instructions.

It is apparent from the above description including the examples, the AgInSbTe phase-change recording medium disclosed herein has material compositions suitable for attaining sufficient sensitivity during either writing or erasing operation, preventing the decrease in the erasure ratio and improving the durability of the media properties at high and multiple linear recording velocities with excellent overwrite characteristics.

By the methods disclosed herein for initializing the recording medium, the initialization steps can be carried out with appropriate beam intensities, to thereby decrease the unevenness in reflectivity resulted from the initialization, as well as in the initialization effect in the layer caused by the overlap of iterative exposures of the beam irradiation.

The thus initialized recording media are found to have disc properties such as low overwrite jitters and decreased fluctuation in disc reflectivity over the disc area, thus assuring high and multiple speed recording capabilities of the recording media.

Furthermore, in the method disclosed herein for determining optimal recording powers, the power can suitably be determined considering the effect of both amplitude m of recorded signals and recording power W, especially in relatively high range of the recording power. This facilitates to obviate previous difficulties of minute adjustments of recording power for each of apparatuses in the production line.

Obviously, numerous additional modifications and variations of the embodiments described above are possible in light of the above teachings. It is therefore to be understood that within the scope of the appended claims, the present invention may be practiced otherwise than as specifically described herein.

This document claims priority and contains subject matter related to Japanese Patent Applications No. 2001-2258, 2001-5734 and 2001-57392, filed with the Japanese Patent Office on January 10, 2001, January 12, 2001 and March 1, 2001, respectively, the entire contents of which are hereby incorporated by reference.

**Claims**

1. An optical recording medium comprising a recording layer containing at least materials capable of carrying out read/write/erase operations through phase changes of said materials therein,
   wherein:
   said recording layer essentially consists of Ag, In, Sb and Te, with a proportion in atomic percent of a(Ag): b(In): c(Sb): d(Te), with $0.1 \leq a \leq 7$, $2 \leq b \leq 10$, $64 \leq c \leq 92$ and $5 \leq d \leq 26$, provided that $a + b + c + d \geq 97$.

2. The optical recording medium according to claim 1,
   wherein:
   said recording layer has a composition satisfying a relation of $88 \leq c + d \leq 98$.

3. An optical recording medium comprising a recording layer containing at least materials capable of carrying out read/write/erase operations through phase changes of said materials therein,

wherein:

said recording layer essentially consists of Ag, In, Sb, Te and Ge, with a proportion in atomic percent of a (Ag): b(In): c(Sb): d(Te): e(Ge), with $0.1 \leq a \leq 7$, $2 \leq b \leq 10$, $64 \leq c \leq 92$, $5 \leq d \leq 26$ and $0.3 \leq e \leq 3$, provided that $a + b + c + d + e \geq 97$.

4. The optical recording medium according to claim 3,

wherein:

said recording layer has a composition satisfying a relation of $88 \leq c + d \leq 98$.

5. An optical recording medium comprising a substrate, and contiguous layers formed on said substrate in order as follows, a first dielectric layer, a recording layer, a second dielectric layer, a metal/alloy layer, and an ultraviolet light curing resinous layer,

wherein:

said recording layer essentially consists of phase change recording materials having a composition as claimed in any one of claims 1 and 3.

6. The optical recording medium according to claim 5,

wherein:

said first dielectric layer, recording layer, second dielectric layer and metal/alloy layer are each formed having a thickness ranging from 30 nm to 220 nm, 10 nm to 25 nm, 10 nm to 50 nm, and 70 nm to 250 nm, respectively.

7. The optical recording medium according to claim 5,

wherein:

said recording medium is rewritable at least once at a linear recording velocity ranging from 9 m/sec to 30 m/sec.

8. The optical recording medium according to claim 6,

wherein:

said metal layer essentially consists of Al and at least one kind of additive with a content ranging from 0.3 weight percent to 2.5 weight percent, said additive being selected from the group consisting of Ta, Ti, Cr and Si.

9. The optical recording medium according to claim 6,

wherein:

said metal/alloy layer essentially consists of Ag and at least one kind of additive with a content ranging from 0 to 4 weight percent, said additive being selected from the group consisting of Au, Pt, Pd, Ru, Ti and Cu.

10. A sputtering target for forming a recording layer, said recording layer being incorporated into an optical recording medium capable of carrying out read/write/erase operations through phase changes of materials therein,

wherein:

said sputtering target essentially consists of Ag, In, Sb and Te, with a proportion in atomic percent of a(Ag): b(In): c(Sb): d(Te), with $0.1 \leq a \leq 7$, $2 \leq b \leq 10$, $64 \leq c \leq 92$ and $5 \leq d \leq 26$, provided that $a + b + c + d \geq 97$.

11. The sputtering target according to claim 10,

wherein:

said sputtering target has a composition satisfying a relation of $88 \leq c + d \leq 98$.

12. A sputtering target for forming a recording layer, said recording layer being incorporated into an optical recording medium capable of carrying out read/write/erase operations through phase changes of materials therein,

wherein:

said sputtering target essentially consists of Ag, In, Sb, Te and Ge, with a proportion in atomic percent of a (Ag): b(In): c(Sb): d(Te): e(Ge), with $0.1 \leq a \leq 7$, $2 \leq b \leq 10$, $64 \leq c \leq 92$, $5 \leq d \leq 26$ and $0.3 \leq e \leq 3$, provided that $a + b + c + d + e \geq 97$.

13. The sputtering target according to claim 12,

wherein:

said sputtering target has a composition satisfying a relation of $88 \leq c + d \leq 98$.

**14.** A method for initializing a phase-change optical recording medium by irradiating said recording medium with a scanning beam spot emitted from a high power semiconductor laser device, said recording medium being capable of carrying out optically read/write/erase operations of information data onto said recording medium,
wherein
an energy density input by said beam spot during one period of through scan is equal to, or less than, 1000 J/m$^2$.

**15.** The method according to claim 14,
wherein a scanning speed of said beam spot is in a range of 3.5 m/sec to 6.5 m/sec.

**16.** The method according to claim 14,
wherein an intensity of the emission from said semiconductor laser device is equal to, or greater than 330 mW.

**17.** The method according to claim 14,
wherein a width of overlapped portion, which is formed as an overlap of irradiated portions, between two neighboring irradiation tracks on said recording medium during two consecutive rotations of said recording medium in initializing steps, is equal to, or less than, 0.5 Wr, where Wr is the width at half maximum of a spatial laser power distribution in a direction perpendicular to beam scanning direction.

**18.** The method according to claim 14,
wherein
an energy density input by said beam spot during one period of through scan is equal to, or larger than, 600 J/m$^2$.

**19.** The method according to claim 18,
wherein a scanning speed of said beam spot is in a range of 3.5 m/sec to 6.5 m/sec.

**20.** The method according to claim 18,
wherein an intensity of the emission from said semiconductor laser device is equal to, or greater than 330 mW.

**21.** The method according to claim 18,
wherein a width of overlapped portion, which is formed as an overlap of irradiated portions, between two neighboring irradiation tracks on said recording medium during two consecutive rotations of said recording medium in initializing steps, is equal to, or less than, 0.5 Wr, where Wr is the width at half maximum of a spatial laser power distribution in a direction perpendicular to scanning direction.

**22.** An apparatus configured to perform at least an initialization operation onto a phase-change optical recording medium by irradiating said recording medium with a scanning beam spot emitted from a high power semiconductor laser device, said initialization operation including at least the steps as claimed in any one of claims 14 through 21.

**23.** A rewritable phase-change optical recording medium, said recording medium being initialized at least by the steps as claimed any one of claims 14 through 21.

**24.** A method for selecting an optimum recording power to suitably carry out read/write/erase operations of information data on a rewritable phase-change optical recording medium through the phase change induced in a recording layer included in said recording medium by laser beam irradiation, said recording layer essentially consisting of Ag, In, Sb and Te elements,
comprising the steps of:

writing a series of information data, as test recording runs, with recording power of laser beam consecutively varied in a range of 15 mW to 18 mW to thereby generate a recorded pattern including low and high reflective portions;
reading out signals from said low and high reflective portions on said recording medium to obtain recorded signal amplitude, m, corresponding to said recording power, P;
calculating a normalized gradient, g(P), using an equation,

$$g(P) = (m/\Delta m)/(P/\Delta P),$$

where $\Delta P$ is an infinitesimal change in the vicinity of P, and $\Delta m$ is an infinitesimal change in the vicinity of P; determining an optimum recording power, after judging adequacy of the magnitude of said recording power based on thus calculated normalized gradient, g(P);

selecting a specific number, S, from the numbers in the range of 0.2 to 2.0 based on said calculated normalized gradient, g(P);

obtaining a value of said recording power, Ps, which coincide with said specific number, S, presently selected;

selecting a specific number, R, based on thus obtained recording power, Ps, from the numbers in the range of 1.0 to 1.7; and

multiplying said recording power, Ps, by said specific number, R, whereby an optimum recording power, $P_0$, is obtained.

25. A phase-change optical recording medium comprising a recording layer, wherein said recording layer contains information recorded in advance therein corresponding to said S and R values specified by said method as claimed in claim 1.

26. The phase-change optical recording medium according to claim 25, wherein $1.2 \le S \le 1.4$, and $1.1 \le R \le 1.3$.

27. The phase-change optical recording medium according to claim 26, wherein said recording medium is recordable at a recording velocity ranging from 4.8 m/sec to 14.0 m/sec.

28. A phase-change optical recording medium comprising a recording layer, wherein said recording layer contains information regarding $P_t$ value recorded in advance therein, said $P_t$ value corresponding to said optimum recording power, $P_0$, specified by said method as claimed in claim 24.

29. The phase-change optical recording medium according to claim 28, wherein said recording medium is recordable at a recording velocity ranging from 4.8 m/sec to 14.0 m/sec.

# FIG. 1

7 PRINTED LAYER

6 PROTECTIVE LAYER

5 REFLECTIVE LAYER

4 SECOND DIELECTRIC LAYER

3 RECORDING LAYER

2 FIRST DIELECTRIC LAYER

1 SUBSTRATE

8 HARD COAT

# FIG. 2

# FIG. 3

# FIG. 4

DOW 1 3T LAND JITTER

V [m/s]

POWER [mW]

JITTER[ns]
- 45–50
- 40–45
- 35–40
- 30–35
- 25–30
- 20–25

# FIG. 5

ENERGY DENSITY

V [m/s]

POWER [mW]

E [J/m2]
- 1000–1400
- 600–1000
- 200–600

# FIG. 6

DOW 1000 3T LAND JITTER

V [m/s]

POWER [mW]

JITTER[ns]
- 45–50
- 40–45
- 35–40
- 30–35
- 25–30
- 20–25

# FIG. 7

ΔRg

V [m/s]

POWER [mW]

- 0.25–0.3
- 0.2–0.25
- 0.15–0.2
- 0.1–0.15
- 0.05–0.1
- 0–0.05

27

# FIG. 8

# FIG. 9

INPUT
SIGNAL

$5T$

# FIG. 10

SERIES OF
RECORDING
PULSES

$t1$    $t2$   $t3$    $t4$

Pw

Pe

Pb

fp    mp    op

# FIG. 11

ADJUSTING TEST RECORDING POWER OR OPTIMUM RECORDING POWER

CONTROL SIGNALS

18

21

23

READOUT SIGNALS

| LASER DRIVING CIRCUIT | RECORDING POWER CONTROL CIRCUIT | RECORD CONTROL UNIT |
|---|---|---|
| 24 | 25 | 26 |

| RECORDING SIGNAL AMPLITUDE (VOLTAGE) MONITORING CIRCUIT | SIGNAL AMPLITUDE (VOLTAGE) COMPUTING CIRCUIT |
|---|---|
| 27 | 28 |

EP 1 223 577 A2